# EUROPEAN PATENT APPLICATION

(11) **EP 4 130 692 A1**
(43) Date of publication of application: **08.02.2023**
(21) Application number: 22789827.7
(22) Date of filing: 25.05.2022
(51) Int. Cl.: G01H 11/08, G01H 1/00, G01H 13/00, G01N 29/04

(54) **DEVICE AND METHOD FOR DESIGNING AMPLIFIER**

(30) Priority: 25.05.2021 KR 20210067260
(71) Applicant: Gentle Energy Corp., Mapo-gu, Seoul 04147 (KR)
(72) Inventor: HONG, Dong Pyo, Seoul 04147 (KR); KIM, Sang Yup, Seoul 04147 (KR); SONG, Charles Kiseok, Seoul 04147 (KR)
(74) Representative: Hoffmann Eitle
(86) International application number: PCT/KR2022/007421
(87) International publication number: WO 2022/250448

(57) **Abstract**

The present disclosure relates to an apparatus and method for designing an amplifier. The method of designing an amplifier executed by a processor in an amplifier design apparatus according to the embodiment includes measuring a frequency of an object by coming into contact with the object wherein the object generates vibration energy, and calculating a natural frequency of the object, in correspondence to a selection of one vibration energy amplifier from among a plurality of vibration energy amplifiers that are preset, loading specification information about the selected vibration energy amplifier, and specifying at least one parameter in the specification information of the vibration energy amplifier so as to coincide with the natural frequency of the object.

## Description

### TECHNICAL FIELD

The present disclosure relates to an apparatus and method for designing an amplifier.

### BACKGROUND ART

In general, because a natural frequency of every material differs, it may be difficult to manufacture an amplifier satisfying a comprehensive natural frequency band. According to the related art, during amplifying vibration, the amplification has been made to a degree of giving a burden to an object or resulting in a failure. Also, even when energy is collected, the energy may not be converted into electromagnetic wave energy that is available for commercial use.

The above-mentioned background art is technical information that the inventor has possessed for the derivation of the present disclosure or acquired in the process of derivation of the present disclosure, and cannot necessarily be said to be a known technique disclosed to the general public prior to the filing of the present disclosure.

### PRIOR ART DOCUMENTS

### PATENT DOCUMENTS

(Patent Document 1) Korean Patent Publication No. 10-0661321 (published on December 19, 2006)

### DESCRIPTION OF EMBODIMENTS

### TECHNICAL PROBLEM

According to an aspect of the present disclosure, provided are an apparatus and method for designing an amplifier capable of amplifying vibration energy by coinciding a natural frequency of an object with a natural frequency of a vibration energy amplifier and converting and collecting the vibration energy as electrical energy.

According to an aspect of the present disclosure, provided are an apparatus and method for designing an amplifier capable of amplifying vibration of wide range.

According to an aspect of the present disclosure, provided are an apparatus and method for designing an amplifier that may not generate an issue on an object while amplifying the vibration.

It will be appreciated by one of ordinary skill in the art that the objectives and effects that could be achieved with the present disclosure are not limited to what has been particularly described above and other objectives and advantages of the present disclosure will be more clearly understood from the following detailed description and embodiments of the present disclosure. Also, it will be readily understood that the objects and advantages of the present disclosure are realized by the means and combinations thereof set forth in the appended claims.

### SOLUTION TO PROBLEM

The method of designing an amplifier executed by a processor in an amplifier design apparatus according to the embodiment includes measuring a frequency of an object by coming into contact with the object wherein the object generates vibration energy, and calculating a natural frequency of the object, in correspondence to a selection of one vibration energy amplifier from among a plurality of vibration energy amplifiers that are preset, loading specification information about the selected vibration energy amplifier, and specifying at least one parameter in the specification information of the vibration energy amplifier so as to coincide with the natural frequency of the object.

An amplifier design apparatus according to an embodiment includes a processor, and a memory that is operably connected to the processor and stores at least one code executed in the processor, wherein the memory stores a code that, when being executed, causes the processor to measure a frequency of an object and calculate a natural frequency of the object by coming into contact with the object wherein the object generates vibration energy, load specification information about a selected vibration energy amplifier in correspondence to a selection of one vibration energy amplifier from among a plurality of vibration energy amplifiers that are preset, and specify at least one parameter in the specification information of the vibration energy amplifier so as to coincide with the natural frequency of the object.

Besides, any other method and system for implementing the present disclosure, and a computer-readable recording medium on which a computer program for executing the method is stored may be further provided.

Other aspects, features and advantages other than those described above will become apparent from the following detailed description of the drawings, claims and disclosure.

### ADVANTAGEOUS EFFECTS OF DISCLOSURE

According to the present disclosure, provided are an apparatus and method for designing an amplifier capable of amplifying vibration energy by coinciding a natural frequency of an object with a natural frequency of a vibration energy amplifier and converting and collecting the vibration energy as electrical energy.

Also, an apparatus and method for designing an amplifier capable of amplifying vibration of wide range may be provided.

Also, an apparatus and method for designing an amplifier that may not generate an issue on an object while amplifying the vibration may be provided.

The present disclosure is not limited to the aforementioned effects, and other effects of the present disclosure may be understood by the following description and will become apparent from the embodiments of the present disclosure.

### BRIEF DESCRIPTION OF DRAWINGS

FIG. 1 is a diagram showing an example of an environment in which an amplifier according to an embodiment is designed.
FIG. 2 is a block diagram schematically showing a configuration of an apparatus for designing an amplifier according to an embodiment.
FIG. 3 is a block diagram schematically showing a configuration of a design management unit in the apparatus for designing an amplifier of FIG. 2.
FIGS. 4A and 4B is a side view of a vibration energy amplifier according to an embodiment.
FIGS. 5A and 5B is a diagram for describing specifying of a variable frame of a vibration energy amplifier according to an embodiment.
FIGS. 6A and 6B is a diagram for describing specifying of a mass of a vibration energy amplifier according to an embodiment.
FIGS. 7A and 7B is a waveform diagram showing a verification result of an apparatus for designing an amplifier according to an embodiment.
FIGS. 8A and 8B is a diagram showing an example of a user terminal on which an apparatus for designing an amplifier according to an embodiment is loaded in the form of an application.
FIG. 9 is a block diagram schematically showing a configuration of an apparatus for designing an amplifier according to another embodiment.
FIG. 10 is a flowchart for describing a method of designing an amplifier according to an embodiment.

### MODE OF DISCLOSURE

The attached drawings illustrate one or more embodiments and are referred to in order to gain a sufficient understanding, the merits thereof, and the objectives accomplished by the implementation. However, this is not intended to limit the present disclosure to particular modes of practice, and it is to be appreciated that all changes, equivalents, and substitutes that do not depart from the spirit and technical scope are encompassed in the present disclosure. The embodiments suggested herein are for rendering the description of the present disclosure complete and are set forth to provide a complete understanding of the scope of the disclosure to one of ordinary skill in the art to which the present disclosure pertains. In the description, certain detailed explanations of the related art are omitted when it is deemed that they may unnecessarily obscure the essence of the present disclosure.

The terms used in the present specification are merely used to describe particular embodiments, and are not intended to limit the present disclosure. An expression used in the singular encompasses the expression of the plural, unless it has a clearly different meaning in the context. In the present specification, it is to be understood that the terms such as "including," "having," and "comprising" are intended to indicate the existence of the features, numbers, steps, actions, components, parts, or combinations thereof disclosed in the specification, and are not intended to preclude the possibility that one or more other features, numbers, steps, actions, components, parts, or combinations thereof may exist or may be added. It will be understood that although the terms "first," "second," etc. may be used herein to describe various components, these components should not be limited by these terms. These components are only used to distinguish one component from another. These components are only used to distinguish one component from another.

In addition, the terms such as "... unit", etc. provided herein may be realized by a hardware component such as a processor or a circuit, and/or a software component executed by a hardware component such as a processor.

Hereinafter, the exemplary embodiments will be described in detail with reference to the accompanying drawings. In the drawings, like reference numerals denote like or corresponding elements, and repeated descriptions thereof will be omitted.

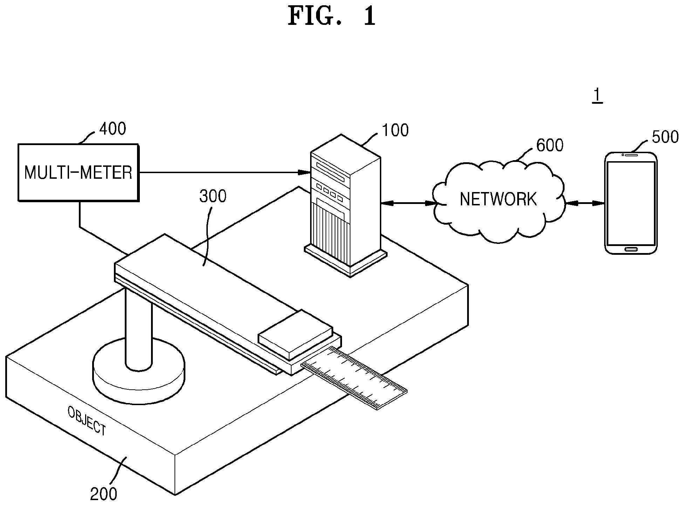

FIG. 1 is a diagram showing an example of an environment in which an amplifier according to an embodiment is designed. Referring to FIG. 1, an amplifier design environment 1 may include an amplifier design apparatus 100, an object 200, a vibration energy amplifier 300, a multi-meter 400, a user terminal 500, and a network 600.

In general, every structure may have an exclusive natural frequency. When a certain natural frequency and frequency of external excitation coincide with each other, there may be a resonance, that is, a magnitude of an amplitude rises dramatically. The magnitude of vibration amplified by the resonance may be in an inverse proportional to an attenuation coefficient. When the attenuation coefficient is large, a small resonance may occur, and contrarily, when the attenuation coefficient is small, a large resonance may occur. By using the above physical characteristics of the object vibration, the vibration energy amplifier 300 according to the embodiment, which may execute selfgeneration and sensing by amplifying the vibration, may be suggested.

The resonance may occur only when the natural frequency of the object 200 and the natural frequency of the vibration energy amplifier 300 coincide with each other. The magnitude of the natural frequency of the object may have various or infinite range, and the natural frequency of the object 200 may vary depending on a kind of the object 200. Therefore, it is easy to install the vibration energy amplifier 300 provided that the natural frequency of the vibration energy amplifier 300 is designed to be different at every time, and the time for repair and maintenance may be reduced. Therefore, the amplifier design apparatus 100 according to the embodiment may continuously change the natural frequency of the vibration energy amplifier 300 based on a specific condition. The continuous change may occur according to which vibration energy amplifier is selected and which parameter in specification information of the selected vibration energy amplifier 300 is specified (e.g., a certain material is added to or excluded from a certain position).

Also, in the embodiment, the amplifier design apparatus 100 may have an algorithm capable of controlling a condition change via a regression analysis function and specifying the natural frequency. Such above algorithm may dramatically reduce a processing time for installation on the object 200 (e.g., five minutes or less) as compared with a case before applying the embodiment. Also, the amplifier design apparatus 100 of the embodiment may include a technology capable of minimizing the attenuation coefficient that is one important element in vibration amplification. When the attenuation coefficient is minimized, an efficiency of harvesting the electric energy of the vibration energy amplifier 300 may be improved. Therefore, when the vibration energy amplifier 300 converts the vibration energy into the electrical energy, a maximum value of available electric energy may be easily obtained.

The amplifier design apparatus 100 may calculate the natural frequency by measuring vibration energy (frequency) of the object 200. In the embodiment, the amplifier design apparatus 100 may be located at the position contacting the object 200 that generates vibration energy, e.g., on the object 200. The amplifier design apparatus 100 may include a vibration sensor (not shown) for measuring the vibration energy of the object 200, and a calculation unit (not shown) that analyzes the vibration energy sensed by the vibration sensor to calculate the natural frequency.

The amplifier design apparatus 100, in response to the selection of one of a plurality of vibration energy amplifiers that are preset, may load specification information of the selected vibration energy amplifier. The amplifier design apparatus 100 may store therein a plurality of kinds of vibration energy amplifiers having various specification. The amplifier design apparatus 100 may load the specification information of one certain vibration energy amplifier from among the plurality of kinds of the vibration energy amplifiers, in response to reception of user's selection. Here, the vibration energy amplifier may include a device that receives and amplifies the vibration energy generated from the object 200 and converts the vibration energy into the electrical energy.

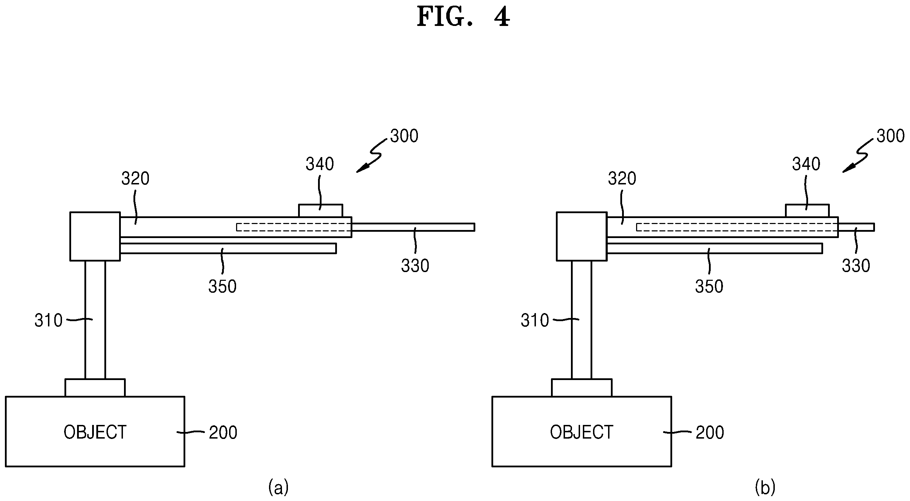

In the embodiment, it will be assumed that a user selects the vibration energy amplifier 300 shown in FIG. 4 from among the plurality of kinds of the vibration energy amplifiers. Therefore, the specification information about the vibration energy amplifier 300 loaded by the amplifier design apparatus 100 may include information about a fixed support (310 of FIG. 4), a fixed frame (320 of FIG. 4), a variable frame (330 of FIG. 4), a mass (340 of FIG. 4), and a power generator (350 of FIG. 4). Hereinafter, detailed specification information of the vibration energy amplifier 300 will be described later. In the embodiment, the vibration energy amplifier 300 may be located at the position contacting the object 200 generating the vibration, e.g., on the object 200.

The amplifier design apparatus 100 may specify at least one parameter in the specification information about the vibration energy amplifier 300, so as to coincide with the natural frequency of the object. Here, specifying of at least one parameter in the specification information of the vibration energy amplifier 300 may include adjusting of a length of the variable frame 330 (see FIG. 4) so as to coincide with the natural frequency of the object, adjusting of a weight of the mass 340 (see FIG. 4), or both.

The amplifier design apparatus 100 may verify whether the natural frequency of the vibration energy amplifier 300, in which one or more of the length of the variable frame 330 (see FIG. 4) and the weight of the mass 340 (see FIG. 4) are adjusted according to the specifying of the parameter, coincides with the natural frequency of the object 200. For verification, the vibration energy amplifier 300 may be located at the position contacting the object 200, e.g., on the object 200 according to the embodiment. When the natural frequency of the vibration energy amplifier 300 and the natural frequency of the object 200 coincide with each other, a resonance may occur. However, when the natural frequency of the vibration energy amplifier 300 and the natural frequency of the object 200 do not coincide with each other, the resonance may not occur.

The amplifier design apparatus 100 may receive a change in a voltage of the vibration energy amplifier 300 from the multi-meter 400 and determine whether the resonance has occurred. In the embodiment, the multi-meter 400 is connected to the power generator 350 (see FIG. 4) of the vibration energy amplifier 300, and may convert the electric energy output from the power generator 350 into the form of voltage and output the voltage to the amplifier design apparatus 100. When there is a section in which the voltage vertically rises (e.g., a section in which the voltage rises by 19 times, from 40 mV to 760 mV) occurs in the voltage change received from the multi-meter 400, the amplifier design apparatus 100 may determine that the resonance has occurred in that section. However, when there is no section in which the voltage vertically rises in the voltage change received from the multi-meter 400, the amplifier design apparatus 100 may determine that the resonance has not occurred.

The amplifier design apparatus 100 receives the change in the voltage of the vibration energy amplifier 300 output from the multi-meter 400, and then, may re-specify at least one parameter in the specification information of the vibration energy amplifier 300 so that the natural frequency of the object 200 and the natural frequency of the vibration energy amplifier 300 coincide with each other and the resonance may occur. Here, the re-specifying of at least one parameter in the specification information of the vibration energy amplifier 300 may include correction of the parameter that has been specified earlier.

In the embodiment, the amplifier design apparatus 100 may independently exist as a server, or an amplifier design function provided by the amplifier design apparatus 100, which includes measuring of the natural frequency of the object 200, loading of the vibration energy amplifier specification information and specifying of a parameter, and verifying of resonance occurrence and re-specifying of the parameter, may be implemented in the form of an application and may be loaded on the user terminal 500.

The user terminal 500 may receive an amplifier design service by accessing the amplifier design application and/or an amplifier design site provided by the amplifier design apparatus 100.

The user terminal 500 may include a communication terminal capable of performing a computing device (not shown), and may include, but is not limited to, a desk top computer, a laptop computer, a tablet personal computer (PC), a smart TV, a mobile phone, a personal digital assistant (PDA), a laptop, a media player, a micro server, a global positioning system (GPS) device, an electronic book terminal, a digital broadcasting terminal, a navigation device, a kiosk, an MP3 player, a digital camera, an electronic appliance, and other mobile or non-mobile computing device manipulated by the user. Also, the user terminal 500 may include a wearable terminal such as a watch, glasses, a hair-band, a ring, etc. having a communication function and a data processing function. The user terminal 500 is not limited to the above description, and terminals through which Web browsing may be performed may be adopted without limitation.

The network 600 may connect the amplifier design apparatus 100 to the user terminal 500. The network 600 may include, but is not limited to, a wired network such as local area network (LAN), wide area network (WAN), metropolitan area network (MAN), integrated service digital network (ISDN), etc., or a wireless network such as wireless LAN, code division multiple access (CDMA), Bluetooth, satellite communication, etc. Also, the network 600 may send/receive information via short-range communication and/or long-distance communication. The short-range communication may include Bluetooth, radio frequency identification (RFID), infrared data association (IrDA), Ultra-Wideband (UWB), Android EE, and Wireless Fidelity (Wi-Fi) technology, and the long-distance communication may include code division multiple access (CDMA), frequency division multiple access (FDMA), time division multiple access (TDMA), orthogonal frequency division multiple access (OFDMA), and single carrier frequency division multiple access (SC-FDMA) technology.

The network 600 may include connections among network elements such as hubs, bridges, routers, and switches. The network 600 may include may include one or more connected networks, for example, multiple network environment including public networks such as Internet and private networks such as secured corporate private networks. Access to the network 600 may be provided via one or more wired or wireless access networks.

Furthermore, the network 600 may support a controller area network (CAN) communication, a vehicle-to-infrastructure (V2I) communication technology, a vehicle-to-everything (V2X) communication technology, a wireless access in vehicular environment (WAVE) communication technology, Internet of things (loT) network and/or an NB network in which distributed components such as objects exchange and process information, and/or 5G communication network. Here, narrowband (NB)-loT is one of low-power/wide-area Internet of Things (loT) technologies using a long-term evolution (LTE) frequency, and may be used for tracking, sensing, meter reading, etc., which intermittently transmit low-capacity data.

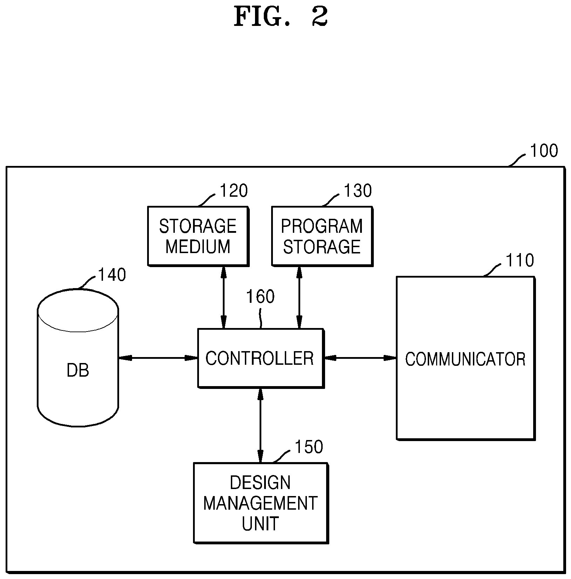

FIG. 2 is a block diagram schematically showing a configuration of an apparatus for designing a vibration energy amplifier according to an embodiment. Hereinafter, descriptions provided above with reference to FIG. 1 are not provided. Referring to FIG. 2, the amplifier design apparatus 100 may include a communicator 110, a storage medium 120, a program storage 130, a database 140, a design management unit 150, and a controller 160.

The communicator 110 may provide a communication interface that is necessary for providing transmission/reception signals between the amplifier design apparatus 100 and the user terminal 500 in the form of packet data, in linkage with the network 600. Moreover, the communicator 110 may receive a signal for requesting certain information from the user terminal and may transmit the information processed by the design management unit 150 to the user terminal 500. Here, the communication network may denote a medium performing a function of connecting the amplifier design apparatus 100 to the user terminal 500, and may include a path for providing the user terminal 500 with an access path through which the user terminal 500 accesses the amplifier design apparatus 100 and transmits/receives information to/from the amplifier design apparatus 100. Also, the communicator 110 may be a device including hardware and software that are necessary for transmitting/receiving signals such as control signals or data signals to/from another network device through wired/wireless connection.

The storage medium 120 may perform a function of temporarily or permanently storing data processed by the controller 160. Here, the storage medium 120 may include a magnetic storage medium or a flash storage medium, but the present disclosure is not limited thereto. The storage medium 120 may include an internal memory and/or external memory, and may include a volatile memory such as DRAM, SRAM, or SDRAM, a non-volatile memory such as one time programmable ROM (OTPROM), PROM, EPROM, EEPROM, mask ROM, flash ROM, NAND flash memory, or NOR flash memory, a flash drive such as SSD, compact flash (CF) card, SD card, micro-SD card, mini-SD card, Xd card, or memory stick, or a storage device such as HDD.

The program storage 130 has control software performing an operation of calculating natural frequency by measuring a frequency of the object 200, an operation of loading specification information about the selected vibration energy amplifier 300 in response to the selection of one of a plurality of vibration energy amplifiers, an operation of specifying at least one parameter from the specification information of the vibration energy amplifier 300 so as to coincide with the natural frequency of the object 200, an operation of verifying whether the resonance occurs because the natural frequency of the vibration energy amplifier 300 and the natural frequency of the object 200 coincide with each other, an operation of re-specifying a certain parameter so that the natural frequency of the vibration energy amplifier 300 and the natural frequency of the object 200 coincide with each other and the resonance occurs, etc.

The database 140 may include management database storing various kinds of amplifiers and specification information of each amplifier. For example, the management database may store the vibration energy amplifier 300 shown in FIG. 4, from among various kinds of amplifiers, and specification information of the vibration energy amplifier 300.

Also, the database 140 may include user database storing information of the user who is to receive the amplifier design service. Here, the user information may include basic user information such as name, affiliation, personal information, gender, age, contact, e-mail, address, images, etc., information about user authentication (login) such as an ID (or e-mail) and password, information related to access, e.g., access country, access location, information about a device used to access, access network environment, etc.

Also, the user database may store exclusive information of the user, history of information and/or category provided to the user who accesses the amplifier design application or the amplifier design site, environment setting information set by the user, resource usage information used by the user, charging and payment information corresponding to the resource usage amount of the user.

The design management unit 150 may calculate the natural frequency by measuring the frequency of the object 200. The design management unit 150 may load specification information of the selected vibration energy amplifier 300, in response to the selection of one of a plurality of vibration energy amplifiers that are preset. The design management unit 150 may specify at least one parameter in the specification information about the vibration energy amplifier 300, so as to coincide with the natural frequency of the object 200. The design management unit 150 may verify whether the resonance, in which the natural frequency of the vibration energy amplifier 300 and the natural frequency of the object 200 coincide with each other, occurs. The design management unit 150 may re-specify a certain parameter so that the natural frequency of the vibration energy amplifier 300 and the natural frequency of the object 200 coincide with each other and the resonance occurs.

The controller 160 is a kind of central processing unit and may control the overall operations of the amplifier design apparatus 100 by driving control software loaded on the program storage 130. The controller 160 may include all kinds of devices capable of processing data, e.g., a processor. Here, 'processor' may denote, for example, a data processing device built in hardware, and includes a physically structured circuit for executing functions expressed as code or instructions included in a program. Examples of the data processing device built into the hardware may include a microprocessor, a central processing unit (CPU), a processor core, a multiprocessor, an application-specific integrated circuit (ASIC), a field programmable gate array (FPGA), etc., but the scope of the present disclosure is not limited thereto.

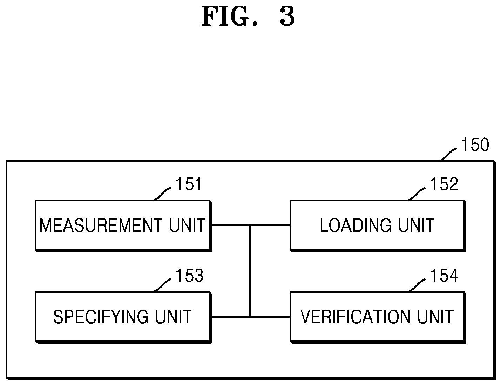

FIG. 3 is a schematic block diagram of the design management unit in the vibration energy amplifier of FIG. 2, and FIG. FIGS. 4A and 4B is a side view of the vibration energy amplifier according to the embodiment. Hereinafter, descriptions provided above with reference to FIGS. 1 and 2 are not provided. Referring to FIGS. 3 and 4, the design management unit 150 may include a measurement unit 151, a loading unit 152, a specifying unit 153, and a verification unit 154.

The measurement unit 151 may measure the frequency of the object 200 by coming into contact with the object 200 generating the vibration energy, and may calculate the natural frequency.

When the vibration energy amplifier 300 comes into contact with the object 200, the measurement unit 151 may measure the frequency of the vibration energy amplifier 300 by using a vibration sensor included therein. In the embodiment, there may be two methods of measuring the frequency of the vibration energy amplifier 300, and one or more of the two methods may be used. First, the vibration energy amplifier 300 comes into contact with the object 200 and the vibration generated from the object 200 may be measured by the vibration sensor. Second, the vibration energy amplifier 300 comes into contact with the object 200 and the object 200 is hit by a hitting tool such as a rubber hammer, and then, the frequency generated by the object 200 may be measured by the vibration sensor.

When the frequency of the object 200 is measured, the measurement unit 151 may use one or more of an impact excitation method and a sine wave excitation method in order to measure the natural frequency of the object 200. In the embodiment, the method of measuring the natural frequency is not limited to the impact excitation method and the sine wave excitation method as described above, and various methods of measuring/transferring physical vibration may be applied.

The impact excitation method may include a method, in which an impact is applied to the object 200 once and a response vibration signal is detected and analyzed. Because the response vibration occurring when the impact excitation is performed has a frequency corresponding to the natural frequency, the natural frequency may be easily measured through the frequency analysis of the response vibration signal.

The sine wave excitation method may include a method in which excitation of a sinusoidal shape is applied to the object 200 while changing the frequency and then a response signal is detected and analyzed, and may be also referred to as a frequency sweeping method. When the sine wave excitation method is used, the object 200 is excited at each excitation frequency and a response vibration component is measured, and then, a point where the largest vibration frequency component exists may be found, which may be the natural frequency.

In the embodiment, when the frequency of the object 200 measured by the measurement unit 151 is too low (e.g., frequency per second is about 10 to 15 or less) or too high, the electric energy may not be collected by the vibration energy amplifier 300. This is because the variable frame 330 and the mass 340 that will be described later may not be specified. In this case, the measurement unit 151 outputs the frequency measurement result so that the user may check.

The loading unit 152 may load the specification information about the selected vibration energy amplifier in correspondence to the selection of one vibration energy amplifier from among the plurality of vibration energy amplifiers that are preset. In the embodiment, from among the plurality of vibration energy amplifiers stored in the database 140, the vibration energy amplifier 300 as shown in FIG. 4 may be selected and the specification information of the vibration energy amplifier 300 may be loaded.

When the loaded information of the vibration energy amplifier 300 is described with reference to FIG. 4, the specification information of the vibration energy amplifier 300 may include design information of the fixed support 310, the fixed frame 320, the variable frame 330, the mass 340, and the power generator 350.

The fixed support 310 may be located above the object 200 generating the vibration energy to receive the vibration energy. In the embodiment, the fixed support 310 may include a material having high elastic coefficient, e.g., stainless steel.

The fixed frame 320 may have an end portion connected to the fixed support 310 and may extend in the lateral direction of the fixed support. In the embodiment, the fixed frame 320 may include a material having high elastic coefficient, e.g., stainless steel. In an alternative embodiment, the fixed frame 320 may be configured to be attachable to/detachable from the fixed support 310. In an embodiment, another fixed frame, of which one of a thickness and a length is adjusted, may be installed on the fixed frame 320 in order to change the natural frequency of the power generator 350.

The variable frame 330 is connected to the other end portion of the fixed frame 320 and may be installed to be slidable in the lateral direction from the other end portion of the fixed frame 320. In the embodiment, the variable frame 330 may include a material having high elastic coefficient, e.g., stainless steel. In the embodiment, the vibration energy of the power generator 350 may be changed according to the sliding length of the variable frame 330 from the other end portion of the fixed frame 320. Here, changing of the vibration energy of the power generator 350 may be the same as changing of the natural frequency of the power generator 350. Also, in the embodiment, an indicator, e.g., a scale, may be indicated on the variable frame 330 so that the sliding length of the variable frame 330 from the other end portion of the fixed frame 320 may be identified. In FIGS. 4A and 4B, the variable frame 330 slides from the fixed frame 320 and has variable length.

In an alternative embodiment, the variable frame 330 may be attachable to/detachable from the fixed frame 320. In an embodiment, another variable frame, of which one of a thickness and a length is adjusted, may be installed on the fixed frame 320 in order to change the natural frequency of the power generator 350. Moreover, when the natural frequency of the power generator 350 and the natural frequency of the object 200 coincide with each other and the resonance occurs only by the fixed frame 320, the variable frame 330 may be omitted from the specification of the vibration energy amplifier 300.

The mass 340 may be located on one or more of the fixed frame 320 and the variable frame 330. In the embodiment, the mass 340 may include a material that may apply a weight, e.g., a magnet. The mass 340 including the magnet may be attachable to/detachable from one or more of the fixed frame 320 and the variable frame 330. In the embodiment, the vibration energy of the power generator 350 may be changed according to the weight of the mass 340. Moreover, when the natural frequency of the power generator 350 and the natural frequency of the object 200 coincide with each other and the resonance occurs even when there is no mass 340, the mass 340 may be omitted from the specification of the vibration energy amplifier 300.

The power generator 350 is connected to the fixed support 310, is spaced apart from the fixed frame 320 while facing the fixed frame 320, and amplifies the vibration energy that the fixed frame 320 and the variable frame 330 receive from the fixed support 310 and converts the vibration energy into the electric energy. In the embodiment, the power generator 350 may include one of a ceramic piezoelectric device, a polymer piezoelectric device, and a hybrid piezoelectric device in which the ceramic and polymer are mixed.

In the embodiment, the power generator 350 may use the ceramic piezoelectric device having excellent power generation amount, the polymer having excellent physical flexibility, or the hybrid piezoelectric device having the polymer and ceramic mixed with each other. Therefore, durability may be obtained due to excellent physical flexibility, and accordingly, power generation may be easily performed. Also, PVDF is basically used as the piezoelectric device, and the piezoelectric device may include barium titanate, PZT crystals, or PZT fibers. In addition, a lead-free piezoelectric material such as NKN-based, BZT-BCT based, BNT based, BNBN based, etc., PLZT, P(VDF-TrFE), crystal, tourmaline, roshellate, barium titanate, ammonium dihydrogen phosphate, ethylene diamine tartarate, etc. may be used.

In an alternative embodiment, the power generator 350 may include a triboelectric generating device. The triboelectric generating device may include one or more of organic, inorganic, and organic/inorganic polymer materials such as the group consisting of polyamide, polyvinyl alcohol, polymethylmethacrylate, polyester, polyurethane, polyvinyl butyral, polyacrylonitrile, natural rubber, polystyrene, polyvinylidene chloride, polyethylene, polypropylene, polyimide, polyvinyl chloride, and polydimethylsiloxane.

The specifying unit 153 may specify at least one parameter in the specification information about the vibration energy amplifier 300, so as to coincide with the natural frequency of the object 200. Here, the specifying of at least one parameter in the specification information of the vibration energy amplifier 300 may include specifying one or more of the length of the variable frame 330 and the weight of the mass 340.

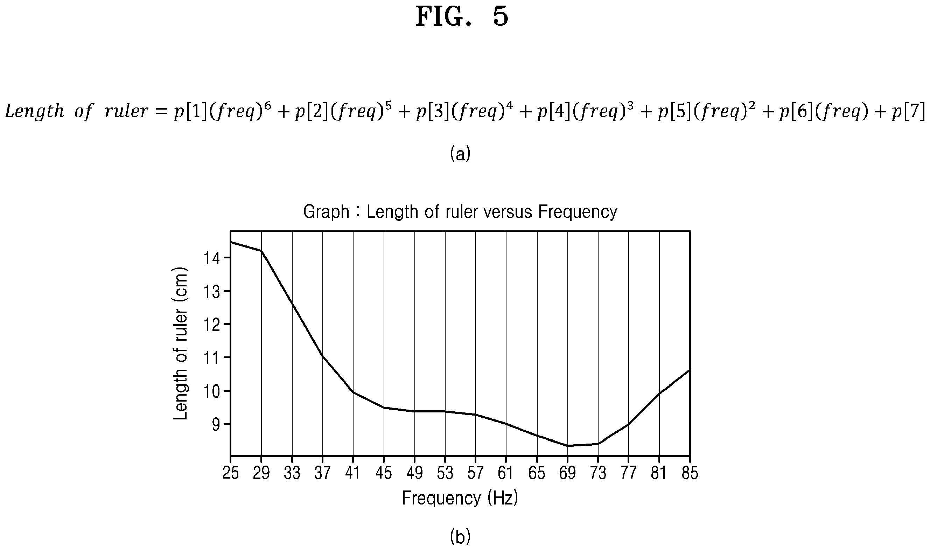

The specifying of the length of the variable frame 330 by the specifying unit 153 will be described below with reference to FIGS. 5A and 5B. Referring to FIG. 5, FIG. 5A shows a linear equation between the length of the variable frame 330 and the natural frequency of the object 200. Here, *freq* denotes the natural frequency of the object 200 and *p* may denote a vector coefficient. In the embodiment, the vector coefficient *p* may have a value between -400 and -300. When the vector coefficient value and the natural frequency of the object 200 are input to the linear equation of FIG. 5A, the length (*Length of ruler*) of the variable frame 330 may be specified. FIG. 5B shows a graph of the length of the variable frame 330 to be specified according to the natural frequency (*freq*) of the object 200. According to FIG. 5B, the length (*Length of ruler,* longitudinal axis) of the variable frame 330, which is to specify the natural frequency (*freq,* transverse axis) of the object 200 may be identified.

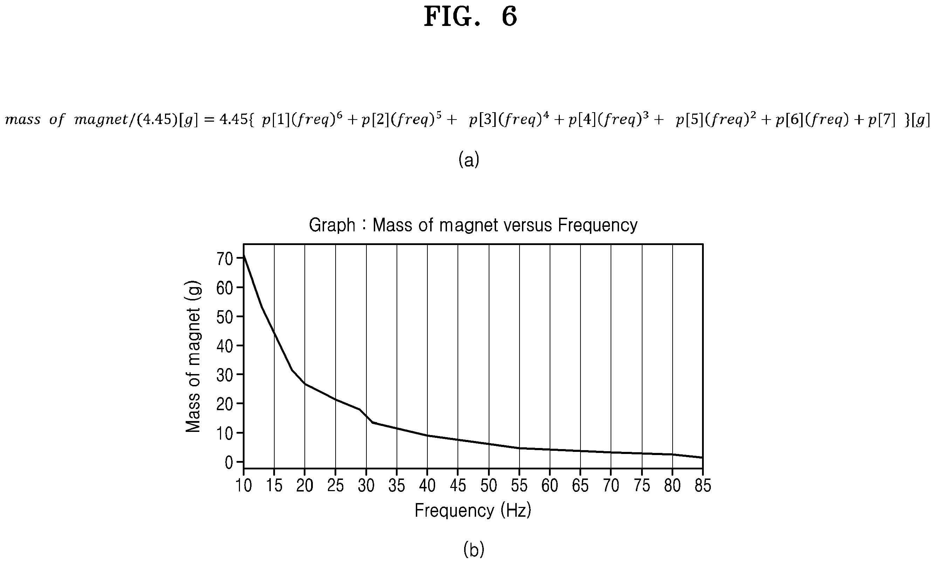

The weight specification of the mass 340 by the specifying unit 153 will be described below with reference to FIGS. 6A and 6B. Referring to FIG. 6, FIG. 6A shows a linear equation between the weight of the mass 340 and the natural frequency of the object 200. Here, *freq* denotes the natural frequency of the object 200 and *p* may denote a vector coefficient. In the embodiment, the vector coefficient *p* may have a value between -2000 and -1000, a value between 10000 and 20000, a value between - 100 and -10, or a value between 100 and 2000. When the vector coefficient value and the natural frequency of the object 200 are input to the linear equation of FIG. 6A, the weight (*mass of magnet*) of the mass 340 may be specified. FIG. 6B shows a graph showing the weight of the mass 340 to be specified according to the natural frequency (*freq*) of the object 200. According to FIG. 6B, the weight (*mass of magnet*) of the mass 340 that is to specify the natural frequency (*freq,* transverse axis) of the object 200.

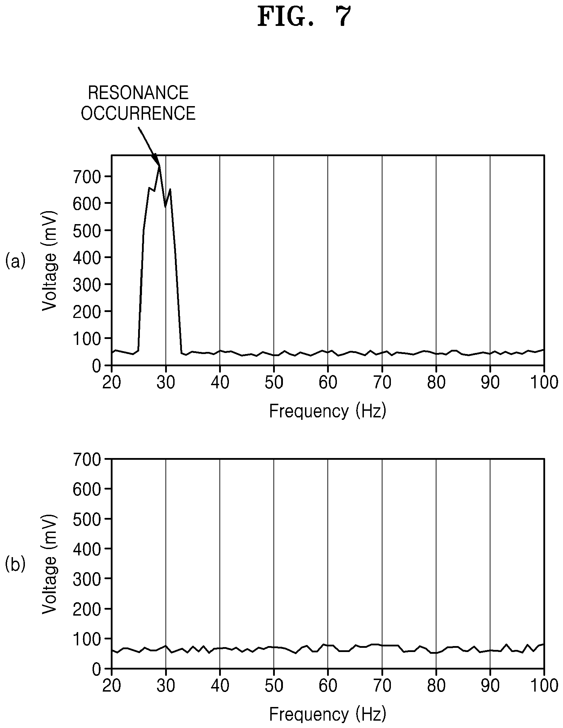

The verification unit 154 may receive a change in a voltage of the vibration energy amplifier 300 from the multi-meter 400 connected to the power generator 350 and determine whether the resonance has occurred. When a section in which the voltage vertically rises occurs, the verification unit 154 may drive an electric energy collecting apparatus (not shown) so as to collect the electric energy output from the vibration energy amplifier 300. FIG. 7A shows a waveform output from the multi-meter 400, which includes a resonance occurrence section, and FIG. 7B shows a waveform output from the multi-meter 400, which does not include a resonance occurrence section. When the resonance occurrence section is not included as shown in FIG. 7B, the verification unit 154 may control the specifying unit 153 so that the resonance may occur. That is, the verification unit 154 may re-specify at least one parameter from the specification information of the vibration energy amplifier 300.

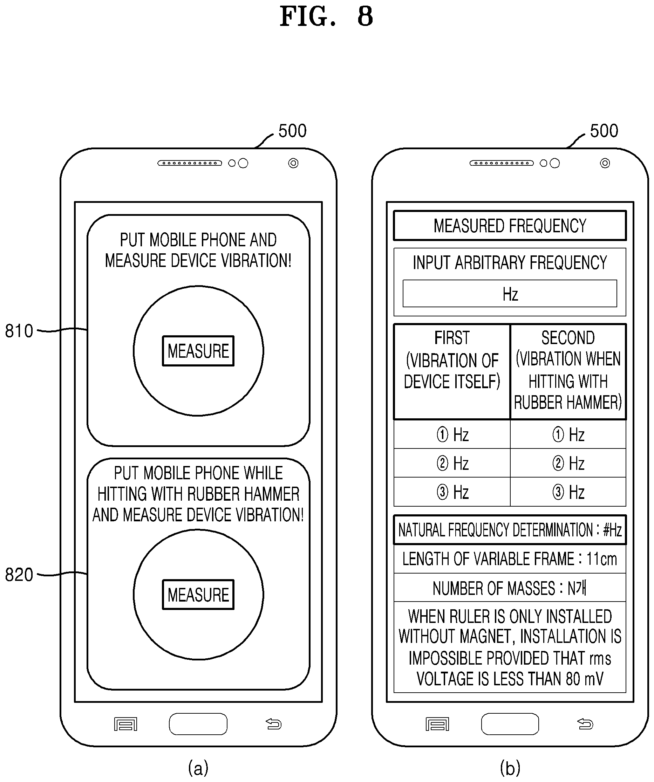

FIGS. 8A and 8B is a diagram showing an example of a user terminal on which an apparatus for designing a vibration energy amplifier according to the embodiment is loaded in the form of an application. Hereinafter, descriptions provided above with reference to FIGS. 1 to 7 are not provided.

FIG. 8A shows information provided to the user in order to measure the frequency of the object 200 while the user terminal 500 is placed on the object 200. In FIG. 8A, 810 indicates that the frequency of the object 200 may be measured by using the vibration sensor, and in FIG. 8B, 820 indicates that the frequency of the object 200 may be measured by hitting the object 200 by using a rubber hammer, etc. In some embodiments, both may be used.

FIG. 8B shows information provided to the user after finishing the measurement of the frequency of the object 200, wherein the information specifies a result of measuring the frequency of the object 200, frequencies measured differently for every measurement time, a result of calculating the natural frequency of the object 200, and accordingly, the length of the variable frame 330 and the weight (or number) of the mass 340 of the vibration energy amplifier 300, which may generate resonance. In the embodiment, the result of measuring the frequency of the object 200 may be an average value of the frequencies that vary depending on every measurement time. The user may adjust the length of the variable frame 330 and/or the weight (or number) of the mass 340 with respect to the vibration energy amplifier 300, according to the screen of FIG. 8B.

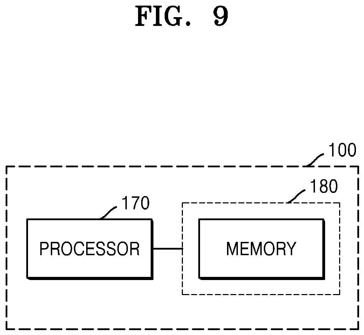

FIG. 9 is a schematic block diagram showing a configuration of an apparatus for designing a vibration energy amplifier according to another embodiment. Hereinafter, descriptions provided above with reference to FIGS. 1 to 8 are not provided. Referring to FIG. 7, the amplifier design apparatus 100 according to another embodiment may include a processor 170 and a memory 180.

In the embodiment, the processor 170 may process functions executed by the communicator 110, the storage medium 120, the program storage 130, the database 140, the design management unit 150, and the controller 160 shown in FIGS. 2 and 3.

The processor 170 may control entire operations of the amplifier design apparatus 100. Here, 'processor' may denote, for example, a data processing device built in hardware, and includes a physically structured circuit for executing functions expressed as code or instructions included in a program. Examples of the data processing device built into the hardware may include a microprocessor, a central processing unit (CPU), a processor core, a multiprocessor, an application-specific integrated circuit (ASIC), a field programmable gate array (FPGA), etc., but the scope of the present disclosure is not limited thereto.

The memory 180 may be operably connected to the processor 170, and may store at least one code in relation to the operation executed by the processor 170.

Also, the memory 180 may temporarily or permanently store the data processed by the processor 170, and may include data established as the database 140. Here, the memory 180 may include a magnetic storage medium or a flash storage medium, but the present disclosure is not limited thereto. The memory 180 may include an internal memory and/or external memory, and may include a volatile memory such as DRAM, SRAM, or SDRAM, a non-volatile memory such as one time programmable ROM (OTPROM), PROM, EPROM, EEPROM, mask ROM, flash ROM, NAND flash memory, or NOR flash memory, a flash drive such as SSD, compact flash (CF) card, SD card, micro-SD card, mini-SD card, Xd card, or memory stick, or a storage device such as HDD.

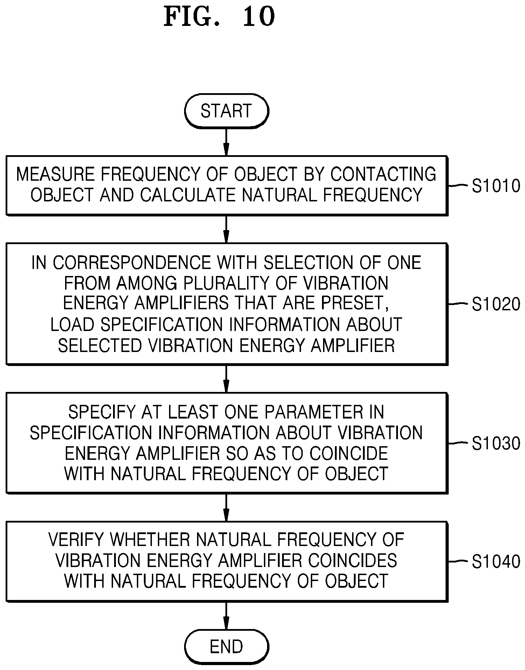

FIG. 10 is a flowchart for describing a method of designing an amplifier according to an embodiment. Hereinafter, descriptions provided above with reference to FIGS. 1 to 9 are not provided. The amplifier design method according to the embodiment will be described under the assumption that the amplifier design apparatus 100 executes the method via the processor 170 with the help of the peripheral components.

Referring to FIG. 10, in operation S1010, the processor 170 may measure the frequency of the object 200 and calculate the natural frequency by coming into contact with the object 200 generating the vibration energy. The processor 170 may measure the frequency of the object 200 by using the vibration sensor in one or more of the two methods describe above. Also, the processor 170 may measure the natural frequency of the object 200 by analyzing the frequency of the object 200 in the sine wave excitation method and/or the impact excitation method.

In operation S1020, the processor 170 may load the specification information about the selected vibration energy amplifier, in response to the selection of one of the plurality of vibration energy amplifiers that are preset. In the embodiment, with the selected vibration energy amplifier 300, the processor 170 may load specification information including the fixed support 310 that is located on the object 200 generating the vibration energy and receives the vibration energy, the fixed frame 320 that has one end portion connected to the fixed support 310 and is extended in the lateral direction of the fixed support 310, the variable frame 330 that is connected to the other end portion of the fixed frame 320 and is installed to be slidable in the lateral direction from the other end portion of the fixed frame 320, the mass 340 that includes a magnet located above one of the fixed frame 320 and the variable frame 330, and the power generator 350 that is connected to the fixed support 310, is separated from the fixed frame 320 to face the fixed frame 320, and amplifies the vibration energy that the fixed frame 320 and the variable frame 330 receive from the fixed support 310 and converts the vibration energy into the electric energy.

In the embodiment, the specification information about the vibration energy amplifier may further include information that the fixed frame 320 is formed to be attachable to/detachable from the fixed support 310, information that the natural frequency of the power generator 350 is changed according to the sliding length of the variable frame 330 from the other end portion of the fixed frame and the indicator for identifying the sliding length from the other end of the fixed frame 320 is shown, information that the power generator 350 includes one of a ceramic piezoelectric device, a polymer piezoelectric device, and a hybrid piezoelectric device in which the ceramic and the polymer are mixed, and information that the fixed frame 320 and the variable frame 330 include stainless steel.

In operation S1030, the processor 170 may specify at least one parameter in the specification information of the vibration energy amplifier 300 so as to coincide with the natural frequency of the object 200. In the embodiment, the processor 170 may specify one or more of the length of the variable frame 330 and the weight of the mass 340 so as to coincide with the natural frequency of the object 200.

In operation S1040, after specifying the parameter, the processor 1700 may verify whether the resonance in which the natural frequency of the vibration energy amplifier 300 and the natural frequency of the object 200 coincide with each other occurs. The processor 170 may re-specify one or more of the length of the variable frame 330 and the weight of the mass 340 so that the natural frequency of the vibration energy amplifier 300 and the natural frequency of the object 200 coincide with each other and the resonance occurs.

One or more of the above embodiments may be embodied in the form of a computer program that may be run in and/or executed by a computer through various elements, and the computer program may be recorded on a non-transitory computer-readable recording medium. Examples of the non-transitory computer-readable recording medium include magnetic media (e.g., hard disks, floppy disks, and magnetic tapes), optical media (e.g., CD-ROMs and DVDs), magneto-optical media (e.g., floptical disks), and hardware devices specifically configured to store and execute program commands (e.g., ROMs, RAMs, and flash memories).

Meanwhile, the computer programs may be specially designed or well known to one of ordinary skill in the computer software field. Examples of the computer programs may include not only machine language code but also high-level language code which is executable by various computing means by using an interpreter.

The singular forms "a," "an" and "the" in the specification of the embodiments, in particular, claims, may be intended to include the plural forms as well. Unless otherwise defined, the ranges defined herein is intended to include values within the range as individually applied and may be considered to be the same as individual values constituting the range in the detailed description.

Also, the steps of all methods described herein may be performed in any suitable order unless otherwise indicated herein or otherwise clearly contradicted by context. The present disclosure is not limited to the described order of the steps. The use of any and all examples, or example language (e.g., "such as") provided herein, is intended merely to better illuminate the present disclosure and does not pose a limitation on the scope of the present disclosure unless otherwise claimed. Also, those of ordinary skill in the art will readily appreciate that many alternations, combinations and modifications, may be made according to design conditions and factors within the scope of the appended claims and their equivalents.

Therefore, the spirit of the present disclosure shall not be limited to the above-described embodiments, and the entire scope of the appended claims and their equivalents will fall within the scope and spirit of the disclosure.

### EXPLANATION OF REFERENCE NUMERALS DESIGNATING THE MAJOR ELEMENTS OF THE DRAWINGS

| | |
|---|---|
| 100: Amplifier design apparatus | 200: Object |
| 300: Vibration energy amplifier | 400: Multi-meter |
| 500: User terminal | 600: Network |

## Claims

1. A method of designing an amplifier, executed by a processor of an amplifier design apparatus, the method comprising:
measuring a frequency of an object by coming into contact with the object wherein the object generates vibration energy, and calculating a natural frequency of the object;
in correspondence to a selection of one vibration energy amplifier from among a plurality of vibration energy amplifiers that are preset, loading specification information about the selected vibration energy amplifier; and
specifying at least one parameter in the specification information of the vibration energy amplifier so as to coincide with the natural frequency of the object.

2. The method of claim 1, wherein
the loading of the specification information about the vibration energy amplifier comprises
loading specification information including a fixed support which is located on the object generating the vibration energy and receives the vibration energy, a fixed frame having one end portion connected to the fixed support and extending in a lateral direction of the fixed support, a variable frame which is connected to the other end portion of the fixed frame and is installed to be slidable in the lateral direction from the other end portion of the fixed frame, a mass including a magnet located on one or more of the fixed frame and the variable frame, and a power generator which is connected to the fixed support, faces the fixed frame while being spaced therefrom, and amplifies the vibration energy that the fixed frame and the variable frame receive from the fixed support and converts the vibration energy into electric energy, and
the specifying of at least one parameter comprises
specifying one or more of a length of the variable frame and a weight of the mass so as to coincide with the natural frequency of the object.

3. The method of claim 2, wherein
the loading of the specification information about the vibration energy amplifier further comprises
loading specification information including the fixed frame that is formed to be attachable to/detachable from the fixed support.

4. The method of claim 2, wherein
the loading of the specification information about the vibration energy amplifier further comprises
loading specification information including the variable frame which makes the natural frequency of the power generator changed according to a sliding length from the other end portion of the fixed frame and has an indicator for identifying a degree of the sliding length from the other end portion of the fixed frame.

5. The method of claim 2, wherein
the loading of the specification information about the vibration energy amplifier further comprises
loading specification information including one or more of the power generator including one of a ceramic piezoelectric device, a polymer piezoelectric device, and a hybrid piezoelectric device having ceramics and polymer mixed with each other, and the power generator including a triboelectric generating device having an organic material, an inorganic material, or an organic/inorganic material.

6. The method of claim 2, wherein
the loading of the specification information about the vibration energy amplifier further comprises
loading specification information including the fixed frame and the variable frame including a material having a high elastic coefficient such as stainless steel.

7. The method of claim 2, further comprising:
after the specifying of the parameter,
verifying whether a natural frequency of the vibration energy amplifier provided at a position coming into contact with the object and the natural frequency of the object coincide with each other and a resonance occurs; and
re-specifying one or more of the length of the variable frame and the weight of the mass so that the natural frequency of the vibration energy amplifier and the natural frequency of the object coincide with each other and the resonance occurs.

8. A computer-readable recording medium on which a computer program for executing the method according to any of claims 1 to 7 by using a computer is stored.

9. An amplifier design apparatus comprising:
a processor; and
a memory that is operably connected to the processor and stores at least one code executed in the processor,
wherein the memory stores a code that, when being executed by the processor, causes the processor
to measure a frequency of an object and calculate a natural frequency of the object by coming into contact with the object wherein the object generates vibration energy,
to load specification information about a selected vibration energy amplifier in correspondence to a selection of one vibration energy amplifier from among a plurality of vibration energy amplifiers that are preset, and
to specify at least one parameter in the specification information of the vibration energy amplifier so as to coincide with the natural frequency of the object.

10. The amplifier design apparatus of claim 9, wherein
the memory stores:
a code that causes the processor to, when loading specification information about the vibration energy amplifier, load specification information including a fixed support which is located on the object generating the vibration energy and receives the vibration energy, a fixed frame having one end portion connected to the fixed support and extending in a lateral direction of the fixed support, a variable frame which is connected to the other end portion of the fixed frame and is installed to be slidable in the lateral direction from the other end portion of the fixed frame, a mass including a magnet located on one or more of the fixed frame and the variable frame, and a power generator which is connected to the fixed support, faces the fixed frame while being spaced therefrom, and amplifies the vibration energy that the fixed frame and the variable frame receive from the fixed support and converts the vibration energy into electric energy; and
a code that causes the processor to specify one or more of a length of the variable frame and a weight of the mass so as to coincide with the natural frequency of the object, when specifying the at least one parameter.

11. The amplifier design apparatus of claim 10, wherein
the memory stores a code that causes the processor to,
when loading the specification information about the vibration energy amplifier, load specification information including the fixed frame that is formed to be attachable to/detachable from the fixed support.

12. The amplifier design apparatus of claim 10, wherein
the memory stores a code that causes the processor to,
when loading the specification information about the vibration energy amplifier, load specification information including the variable frame which makes the natural frequency of the power generator changed according to a sliding length from the other end portion of the fixed frame and has an indicator for identifying a degree of the sliding length from the other end portion of the fixed frame.

13. The amplifier design apparatus of claim 10, wherein
the memory stores a code that causes the processor to,
when loading the specification information about the vibration energy amplifier, load specification information including one or more of the power generator including one of a ceramic piezoelectric device, a polymer piezoelectric device, and a hybrid piezoelectric device having ceramics and polymer mixed with each other, and the power generator including a triboelectric generating device having an organic material, an inorganic material, or an organic/inorganic material.

14. The amplifier design apparatus of claim 10, wherein
the memory stores a code that causes the processor to,
when loading the specification information about the vibration energy amplifier, load specification information including the fixed frame and the variable frame including a material having a high elastic coefficient such as stainless steel.

15. The amplifier design apparatus of claim 10, wherein
the memory stores a code that causes the processor to,
after specifying the parameter, verify whether a natural frequency of the vibration energy amplifier provided at a position coming into contact with the object and the natural frequency of the object coincide with each other and a resonance occurs; and
re-specify one or more of the length of the variable frame and the weight of the mass so that the natural frequency of the vibration energy amplifier and the natural frequency of the object coincide with each other and the resonance occurs.
